# EUROPEAN PATENT SPECIFICATION

(11) **EP 2 840 877 B1**
(45) Date of publication and mention of the grant of the patent: **07.09.2016**
(21) Application number: 12874529.6
(22) Date of filing: 18.04.2012
(51) Int. Cl.: H05K 13/02, B65H 19/18, B65H 21/00, B65H 20/16, B65H 23/188

(54) **AUTOMATIC SPLICING DEVICE**
AUTOMATISCHE SPLEISSVORRICHTUNG
DISPOSITIF DE RACCORDEMENT AUTOMATIQUE

(43) Date of publication of application: 25.02.2015
(73) Proprietor: Fuji Machine Mfg. Co., Ltd., Chiryu-shi Aichi 472-8686 (JP)
(72) Inventor: CHI, Xiao Dong, Chiryu-shi Aichi 472-8686 (JP)
(74) Representative: Grünecker Patent- und Rechtsanwälte PartG mbB
(86) International application number: PCT/JP2012/060515
(87) International publication number: WO 2013/157109

(56) References cited:
- EP-A1- 0 967 851
- WO-A1-2009/051469
- JP-A- H0 679 788
- JP-A- H0 964 109
- JP-A- H04 243 757
- JP-A- H08 107 268
- JP-A- 2002 134 565
- JP-A- 2002 207 286
- JP-A- 2006 149 806
- JP-A- 2010 120 344
- JP-A- 2011 159 677
- US-A1- 2004 094 451

## Description

### Technical Field

The present invention relates to an automatic splicing device for automatically connecting the tail end of first carrier tape number wound around first reel on a feeder equipped in a component supply device of a component mounter to the leading end of a second carrier tape wound around a second reel which is to be exchanged.

### Background Art

For example, disclosed in patent literature 1 is an automatic splicing device for automatically connecting the respective tapes from a first reel and the second reel. This automatic splicing device comprises a first cutting device for cutting the unnecessary section from the tail end of the tape of the first reel, a second cutting device for cutting the unnecessary section from the leading end of the tape of the second reel, and a joining device for connecting the cut tail end of a first tape to the leading end of a second tape.

When performing tape connecting by this automatic splicing device, the operator first cuts the tail end of the first tape and the leading end of the second tape to any length. Next, the first tape tail end and the second tape leading end are respectively inserted into the first cutting device and the second cutting device. When this is done, first and second cutting devices start and convey the respective inserted first and second tapes towards the cutting position and stop conveying at the cutting position. Then, pins are engaged into the holes used for indexing in first and second tapes and the respective positions of first and second tapes are determined, and the respective tapes are cut at the center position.between the cavities in which components are stored in first and second tapes by a cutter.

Afterwards the first and the second tapes are conveyed towards the joining position in the joining device and conveying stops at the joining position. Then, pins are engaged into the holes used for indexing in first and second tapes and the respective positions of first and second tape are determined, joining tape is attached to both the top and bottom of the first tape tail end and second leading tape end. This completes connecting the first and second tapes.

### Citation List

### Patent Literature

PTL 1: JP-A-04-243757

### Summary of Invention

### Technical Problem

For the automatic splicing device according to the preamble of claim 1 as disclosed in patent literature 1, because the center position between cavities of first and second tapes is cut, pins engage with the indexing holes of first and second tapes to decide to the position thereof. In other words, it is only possible to support tapes for which there is a fixed relationship between the pitch between the cavities and the indexing hole pitch. Therefore, with tape that has a pitch that is different to the pitch between cavities of tape which can be supported by this automatic splicing device, the center position between cavities cannot be cut.

The present invention is an item that takes the above issue into account whose object is an automatic splicing device which can support connecting tapes for which the pitch between cavities differs.

### Solution to Problem

In order to solve the above problems, the invention from claim 1 is a splicing device which connects the first tape and the second tape provided with cavities for storing components and indexing holes at fixed intervals using splicing tape, comprising: first and second cutting devices for respectively cutting at first and second cutting positions the respective unnecessary sections at the tail end of the first tape and the leading end of the second tape; first and second indexing devices for conveying the first and second tapes respectively along first and second conveyance paths and positioning the cutting points of the first and second tapes in order at the first and second cutting positions and the splicing position; first and second detection devices for detecting respectively the first and second cavities of the first and second tapes conveyed along the first and second conveyance paths, and the first and second components stored in the first and second cavities, at first and second detection positions provided respectively in the first and second conveyance paths; a control device for controlling each operation of the first and second tape indexing devices, the first and second cutting devices and the joining device; wherein the control device has: a pitch calculating means for calculating the predetermined pitch between the first and second cavities based on at least one of the first and second cavities detected at at least one of the first and second detection devices; a first and second cutting point calculating device for calculating respectively the first and second cutting points of the first and second tapes from first distance between the first detection position and the first cutting position, and second distance between the second detection position and the second cutting position, and the predetermined pitch calculated by the pitch calculating means, based on a first and second component presence signal output after the first and second detections devices detect a switch from first and second cavities without the first and second components to first and second cavities with the first and second components; and a first and second cutting position deciding means which control the first and second tape indexing devices and move the first and second tapes first and second distances after the first and second component presence signal is output to respectively decides the conveyance positions of the first and second cutting points at the first and second cutting positions.

For the present invention from claim 2, the control device from claim 1 uses a first and second splicing positioning means wherein, when the first and second cutting points positioned at the first and second cutting positions are cut by the first and second cutting devices, the first and second tape indexing devices are controlled so that the first and second cutting points are moved third and fourth distances between the first and second cutting points and the splicing position so that the first and the second cutting points are positioned at the splicing position.

For the present invention from claim 3, with respect to claim 1 or claim 2, the first and second cuttings devices comprise: first and second cutters which cut the first and second cutting points positioned at the first and second cutting positions of the first and second tapes and which are attached to be movable up and down; and first and second pressing members provided adjacent to the first and second cutters so that they can move up and down, which press and fix the area around the first and second cutting points of the first and second tapes respectively positioned at the first and second cutting positions.

### Advantageous Effects of Invention

According to the invention related to claim 1, the control device, based on first and second component presence signals, respectively calculates the first and second cutting points of first and second tapes from the predetermined pitch of first and second cavities and first and second distances between first and second detection positions and first and second cutting positions. By this, cutting points can be specified even when tapes have different pitches between cavities, and the tapes can be spliced reliably.

According to the embodiment related to claim 2, the control device moves first and second cutting points third and fourth distances which are between first and second cutting positions and the splicing position such that first and second cutting points are positioned at the splicing position. By this, first cutting point and second cutting point can be reliably matched, and the splicing accuracy of first and second tapes can be improved.

According to the embodiment related to claim 3, first and second pressing members press and fix the area around first and second cutting points of first and second tapes respectively positioned at first and second cutting positions. By this, because the deviation of first and second tapes when first and second cutting points of first and second tapes are cut by first and second cutters can be prevented, the cutting accuracy of first and second tapes can be improved.

### Brief Description of Drawings

[FIG. 1] FIG. 1 is a diagram showing a tape feeder suitable for an embodiment of the present invention.
[FIG. 2] FIG. 2 is a diagram showing carrier tape held in a tape feeder.
[FIG. 3] FIG. 3 is a cross section view along line 3-3 of FIG. 2.
[FIG. 4] FIG. 4 is a perspective view showing the entire splicing device indicated in the embodiment of the present invention.
[FIG. 5] FIG. 5 is a diagram of the splicing device with the lid open.
[FIG. 6] FIG. 6 is a diagram showing the splicing device with the splicing tape loaded.
[FIG. 7] FIG. 7 is a diagram showing the supply reel wound with splicing tape which is used in the splicing device.
[FIG. 8] FIG. 8 is a diagram showing the affixing state of the splicing tape on the protective tape.
[FIG. 9] FIG. 9 is a diagram showing the attached state of the protective tape, splicing tape, and base paper.
[FIG. 10] FIG. 10 is a schematic diagram showing the base paper indexing device.
[FIG. 11] FIG. 11(A) is a top view of carrier tape to be connected in the splicing device and FIG. 11 (B) is the carrier tape viewed from the side.
[FIG. 12] FIG. 12 is a diagram showing the types of carrier tapes which can be connected in the splicing device.
[FIG. 13] FIG. 13 is a diagram showing the splicing device with the housing and lid removed and the interior exposed.
[FIG. 14] FIG. 14 is a diagram showing a schematic outline of the splicing device.
[FIG. 15] FIG. 15 is a flow chart to illustrate the splicing preparation processes of the splicing device.
[FIG. 16] FIG. 16 is a schematic diagram showing the carrier tape insertion process of the splicing preparation processes.
[FIG. 17] FIG. 17 is a diagram showing the carrier tape cavity detection process of the splicing preparation processes.
[FIG. 18] FIG. 18 is a diagram showing the process for positioning the cutting point of the carrier tape of the splicing preparation processes.
[FIG. 19] FIG. 19 is a diagram to illustrate the calculation process for the cutting point and cavity pitch of the carrier tape of the splicing preparation processes.
[FIG. 20] FIG. 20 is a diagram showing the pressing process around the cutting point of the carrier tape of the splicing preparation processes.
[FIG. 21] FIG. 21 is a diagram showing the cutting process at the cutting point of the carrier tape of the splicing preparation processes.
[FIG. 22] FIG. 22 is a diagram showing the cutting process of embossed carrier tape of the splicing preparation processes.
[FIG. 23] FIG. 23 is a diagram showing the completed state of cutting at the cutting point of the carrier tape of the splicing preparation processes.
[FIG. 24] FIG. 24 is a diagram showing the process for positioning the carrier tape at the splicing position of the splicing preparation processes.
[FIG. 25] FIG. 25 is a perspective view showing the joining device of the splicing device.
[FIG. 26] FIG. 26 is a top view showing the joining means.
[FIG. 27] FIG. 27 is a front view from the direction of arrow 27 of FIG. 26.
[FIG. 28] FIG. 28 is a right side view from the direction of arrow 28 of FIG. 26.
[FIG. 29] FIG. 29 is a left side view from the direction of arrow 29 of FIG. 26.
[FIG. 30] FIG. 30 is a cross section showing the relationship of the carrier tape and splicing tape at the splicing position.
[FIG. 31] FIG. 31(A), (B) and (C) are cross section views along the line 31-31 of FIG. 29 showing the splicing operation.

### Description of Embodiments

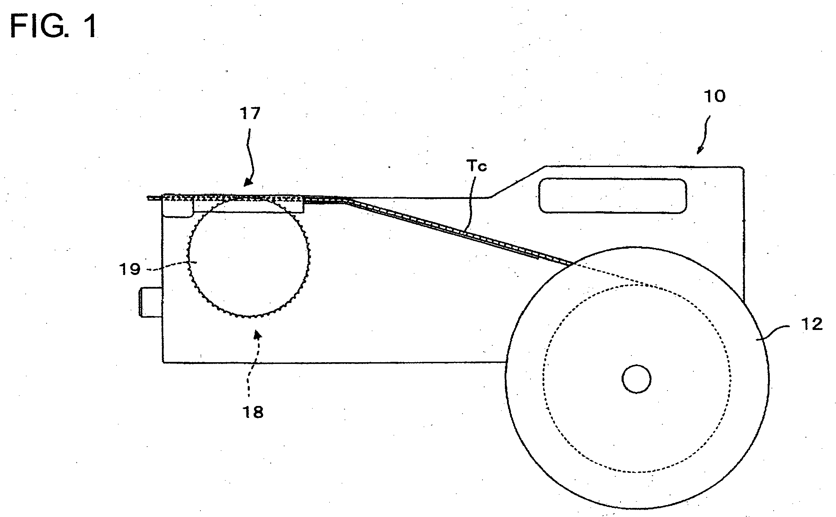

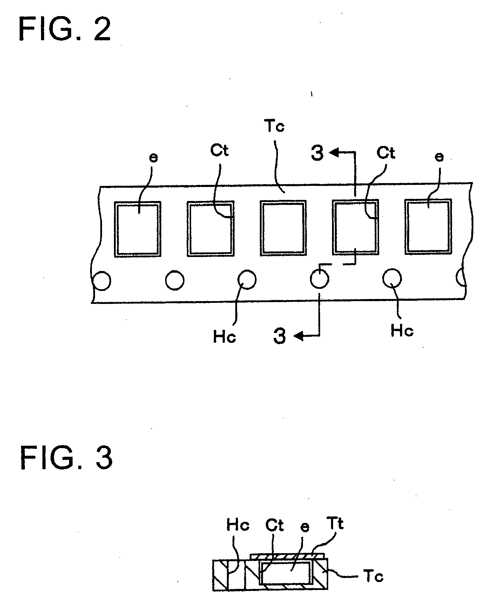

The following describes an embodiment of the present invention based on the figures. FIG. 1 shows tape feeder 10 which is removably loaded onto the component supply device of a component mounter, and reel 12 with carrier tape Tc wound around is removably attached to tape feeder 10. Carrier tape Tc, as shown in FIG. 2, is formed in a long, narrow manner with a predetermined width, and is provided with multiple cavities Ct arranged lengthwise at a fixed pitch, and electronic components e to be mounted on a circuit board are stored respectively in these cavities Ct. The upper section of cavities Ct is open and covered by cover tape Tt (refer to FIG. 3) which is affixed to the surface of carrier tape Tc.

Along one edge in the widthwise direction of carrier tape Tc, indexing holes Hc are formed at the same pitch as cavities Ct, or at twice the pitch of cavities Ct, such that these indexing holes Hc have a fixed positional relationship with cavities Ct. Provided in tape feeder 10 is a fixed amount indexing mechanism 18 for indexing carrier tape Tc wound around reel 12 by fixed amounts and supplying electronic components e one by one to component supply position 17 provided at the tip section of tape feeder 10. Fixed amount indexing mechanism 18 is rotatably provided on the main body of tape feeder 10, and comprises sprocket 19 for engaging with indexing holes Hc of carrier tape Tc and a motor which is omitted from the figures for rotating sprocket 19 one pitch each time.

For carrier tapes Tc used on component mounters, there are multiple types each with different pitches for cavities Ct, and the relationship between indexing holes Hc and the pitch of cavities Ct and cavities Ct is decided based on the type of carrier type Tc. It follows that, as given below, by recognizing the pitch of cavities Ct by image processing, it is possible to know the type of carrier tape Tc, and based on this, the position of indexing holes Hc of carrier tape Tc can be recognized, and the cutting position of carrier tape Tc during splicing can be decided.

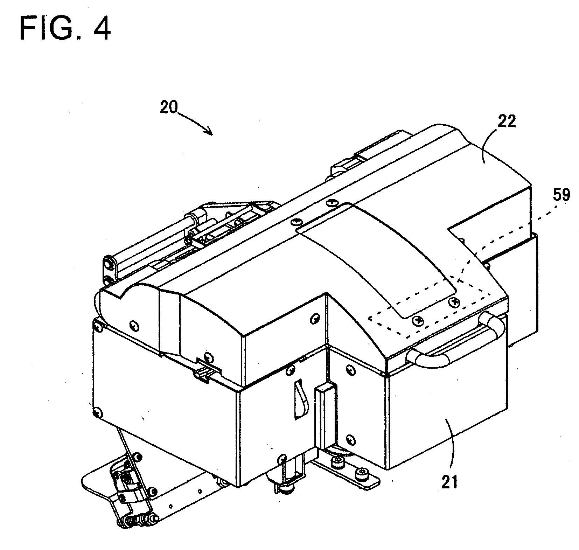

Splicing device 20 is a device for automatically connecting the tail end of carrier tape wound around the current reel loaded on a feeder loaded on the component supply device and the leading end of carrier tape wound around the next reel which is to be exchanged. Splicing device 20, as shown in FIG. 4, comprises box-like housing 21 and lid 22 on the upper surface of housing 21 which can be opened/closed, and is loaded on a cart and so on which is omitted from the figures to be movable between feeders loaded on the component supply device of a component mounter. Lid 22 is closed during splicing and opened when removing carrier tape Tc after splicing.

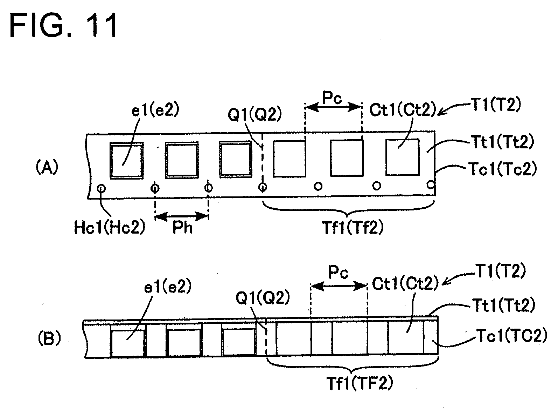

For the first carrier tape T1 and second carrier tape T2 spliced by splicing device 20, as shown in FIG. 11, as well as first cavities Ct1 (second cavity Ct2) in which are stored the same type of components e1 (second components e2) being provided at predetermined pitch Pc, first indexing holes Hc1 which can engage with teeth 131a (131b) of first sprocket 13a (second sprocket 13b) of first tape indexing device 10 (second tape indexing device 11) given below, are formed parallel to first cavities Ct1 (second cavities Ct2) at predetermined pitch Ph.

First and second carrier tapes T1 and T2 are cut by automatic splicing device 20 at first and second cutting points Q1 and Q2 which can be anywhere and then aligned, and are spliced using splicing tape 30 described below. For first cutting point Q1 (second cutting point Q2), for example, the intermediate position between first cavity Ct1 (second cavity Ct2) in which there is first component e1 (second component e2) and empty first cavity Ct1 (second cavity Ct2) in which there is no first component e1 (second component e2) is selected. First carrier tape T1 (second carrier tape T2) on which empty first cavities Ct1 (second cavities Ct2) lie in a row after cutting is discarded as first unnecessary section Tf1 (second unnecessary section Tf2). Here, in order to leave any quantity of empty first cavities Ct1 (second cavities Ct2), the intermediate position of adjacent empty first cavities Ct1 (second cavity Ct2) can also be selected as first cutting point Q1 (second cutting point Q2).

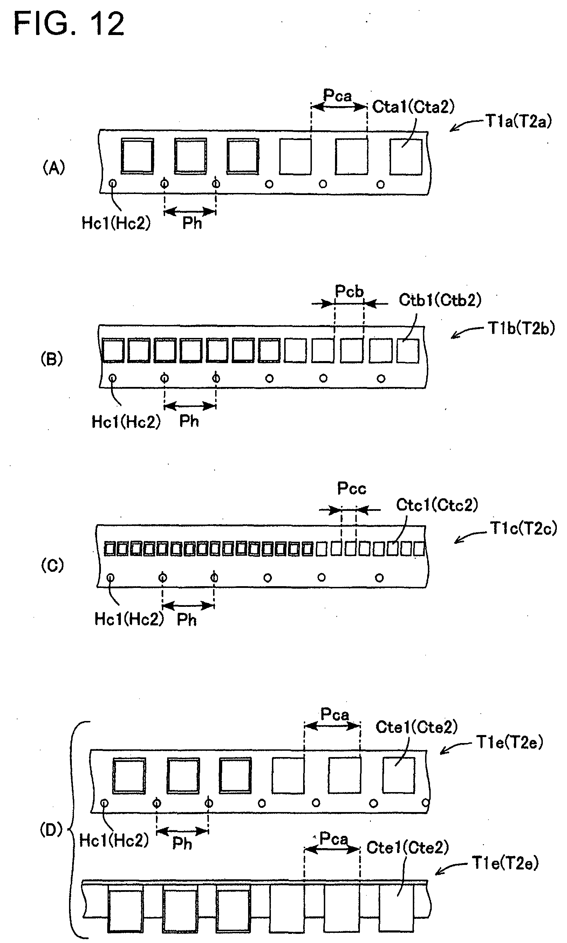

As shown in FIG. 11, as first carrier tape T1 (second carrier tape T2) which can be connected in automatic splicing device 20, there are three types of carrier tapes in which first indexing holes Hc1 (second indexing holes Hc2) are formed at the same predetermined pitch Ph, but in which first cavities Ct1 (second cavities Ct2) are provided at differing pitches Pc (Pca, Pcb, and Pcc). In other words, the first type of first carrier tape T1a (second carrier tape T2b) is tape (refer to FIG. 12[A]) provided with a predetermined pitch Pca (=Ph) such that one first cavity Cta1 (second cavity Cta2) is present at the intermediate position of adjacent first indexing holes Hc1 (second indexing holes Hc2).

The second type of first carrier tape T1b (second carrier tape T2b) is tape (refer to FIG. 12[B]) provided with a predetermined pitch Pcb (=Ph/2) such that one first cavity Ctb1 (second cavity Cta2) each is present at the position matching first indexing holes Hc1 (second indexing holes Hc2) and at the intermediate position of adjacent first indexing holes Hc1 (second indexing holes Hc2).

The third type of first carrier tape T1 (second carrier tape T2) is tape (refer to FIG. 12[C]), provided with a predetermined pitch Pcc (=Ph/4) such that one first cavity Ct1 (second cavity Cta2) is present at the position matching first indexing holes Hc1 (second indexing holes Hc2), and three first cavities Ctc1 (second cavities Cta2) are present between adjacent first indexing holes Hc1 (second indexing holes Hc2).

Also, first embossed tape T1e (second embossed tape T2e) for which first cavities Cte1 (second cavities Cte2) protrude in the thickness direction due to the height of first component e1 (second component e2) being tall can be connected by automatic splicing device 20 (refer to FIG. 12[D]). In the same way as the three types of tape above, first embossed tape T1e (second embossed tape T2e) is tape in which first indexing holes Hc1 (second indexing holes Hc2) are formed at the same predetermined pitch Ph, but in which first cavities Cte1 (second cavities Cte2) are provided at differing pitches Pc (Pca, Pcb, Pcc).

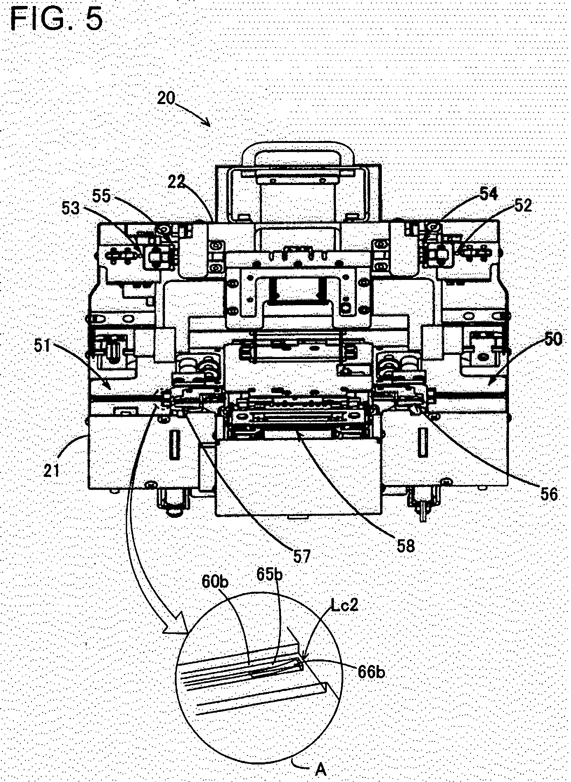

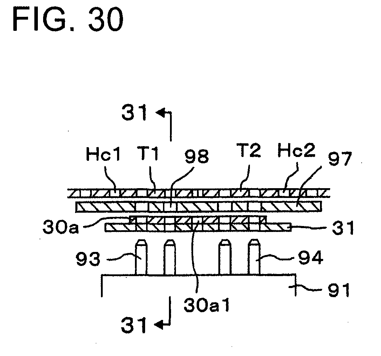

Splicing device 20, as well as taking in two carrier tapes T1 and T2 to be spliced from the left and right of FIG. 5, takes in, in a perpendicular direction to that, which is the up direction of FIG. 5. , protective tape 31 affixed with splicing tape 30 to connect two carrier tapes T1 and T2. Further, the respective ends of two carrier tapes T1 and T2 are joined to each other by splicing tape 30 at splicing position LS at which protective tape 31 and carrier tapes T1 and T2 intersect. Here, as shown in FIG. 30, splicing tape 30 affixed to protective tape 31, is taken in to splicing position LS with the attachment surface facing up and two carrier tapes T1 and T2 are taken in above this splicing tape 30.

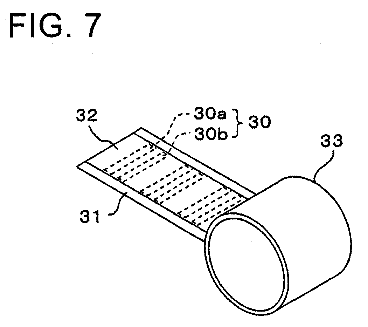

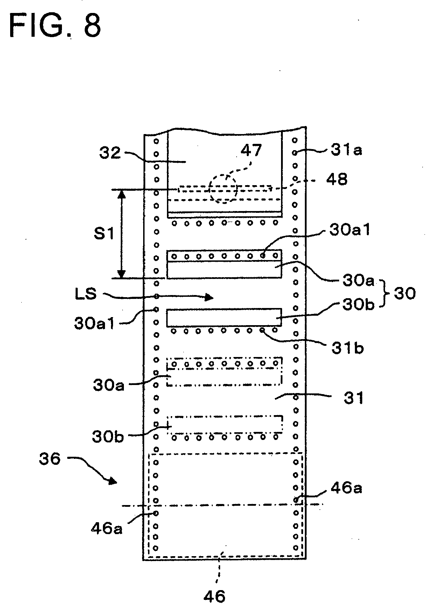

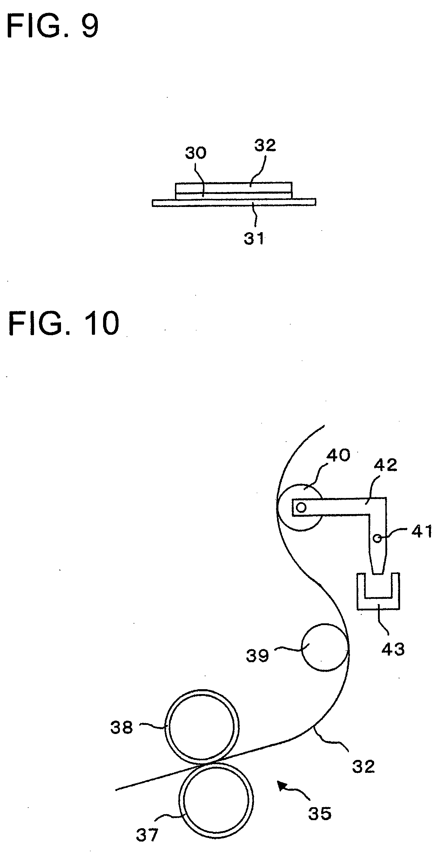

For splicing tape 30, as shown in FIG. 8, on the upper surface of connected protective tape 31, two pieces, splicing tape 30a and splicing tape 30b, which make up one set to be attached to both sides of two carrier tapes T1 and T2 and straddling thereof, are affixed at a predetermined interval in the lengthwise direction of protective tape 31. Multiple of these two pieces of splicing tape 30a and 30b are affixed at predetermined intervals in the lengthwise direction of protective tape 31. The upper surface of splicing tapes 30a and 30b consists of an attachment surface to be attached to both surfaces of two carrier tapes T1 and T2 and straddling thereof, and on this attachment surface, connected base paper 32 is attached, and the three-layer structure (refer to FIG. 9) of these base paper 32, splicing tape 30, and protective tape 31 is, as shown in FIG. 7, wound around supply reel 33 in a roll shape.

The width dimension of protective tape 31 is larger than the width dimension of base paper 32, and the edges of protective tape 31 in the width direction protrude from the edges of base paper 32 in the width direction, and holes 31a for indexing the protective tape are formed at fixed intervals in the lengthwise direction in those protruding sections. On the other hand, the width dimension of splicing tape 30 is the same as the width dimension of base paper 32, and splicing tapes 30 with two pieces as one set are affixed to protective tape 31 along the width direction inside holes 31a for indexing. Positioning holes 30a1 are respectively formed in splicing tape 30a which is one of the two pieces of one set at the same pitch as indexing holes Hc1 and Hc2 formed in carrier tapes T1 and T2, and positioning holes 31b are respectively formed in protective tape 31 at the same pitch as indexing holes Hc and Hc2 formed in carrier tapes T1 and T2 at a position adjacent to splicing tape 30b which is the other of the two pieces of one set. Here, holes 31a for indexing and positioning holes 31b formed in protective tape 31 are formed by a punching press after splicing tapes 30a and 30b are affixed to protective tape 31 in a specified position so to be aligned with positioning holes 30a1 formed in splicing tape 30a.

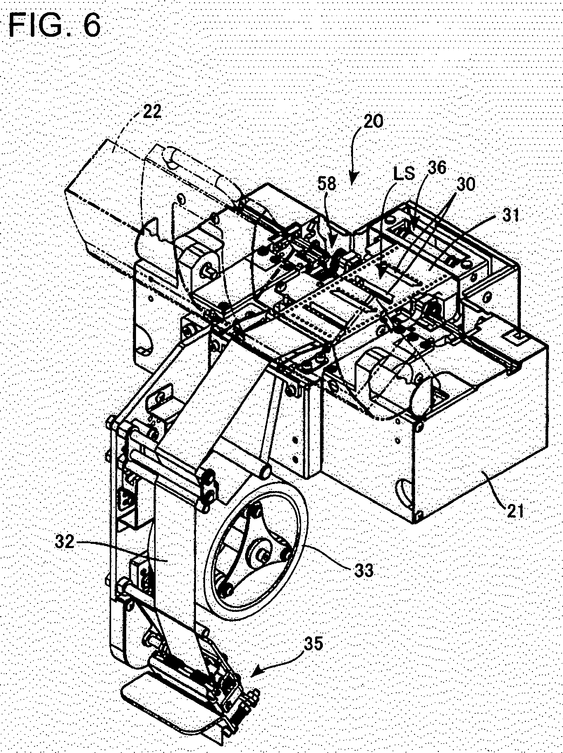

In splicing device 20, as shown in FIG. 6, rotatable supply reel 33 wound in a roll shape with the three-layer structure which includes splicing tape 30, base paper indexing device 35 for indexing base paper 32 peeled from splicing tape 30, and protective tape indexing device 36 for indexing protective tape 31 peeled from splicing tape 30 are arranged along the line sideways from splicing position LS at which two carrier tapes T1 and T2 are spliced.

For the attachment strength of base paper 32 and protective tape 31 attached to both sides of splicing tape 30, the attachment strength for protective tape 31 is stronger, so that splicing tape 30 is not peeled from protective tape 31 even when base paper 32 is peeled from splicing tape 30. However, when carrier tapes T1 and T2 are attached to the attachment surface of splicing tape 30 from which base paper 32 has been peeled, that attachment force is stronger than the attachment force for protective tape 31, so that protective tape 31 can be easily peeled from splicing tape 30.

The three-layer structure of base paper 32, splicing tape 30, and protective tape 31 is attached to splicing jig 20 in a state wound around supply reel 33, and the leading end thereof is pulled out from supply reel 33. Then, base paper is peeled and folded back by an operator, and base paper 32 is indexed by base paper indexing device 35 and put into a base paper collection box which is omitted from the figures. Base paper indexing device 35, as shown in FIG. 10, has driving gear 37 and driven gear 38 each formed with gears in the outer surface. Driven gear 38 is attached such that it can contact and be separated from driving gear 37, and normally the outside of driven gear 38 is pressed against the outside of driving gear 37 by the biasing force of a spring which is omitted from the figures. By this, driven gear 38 is separated from driving gear 37 and base paper 32 is sandwiched between both gears 37 and 38, and in that state, by moving driving gear 37 using a motor omitted from the figures, base paper 32 is indexed by the rotation of both gears 37 and 38.

Upstream of driving gear 37 and driven gear 38, contacting roller 40 which can be contacted by base paper 32 guided by guide roller 39 is provided. Contacting roller 40 is attached to an end of dog 42 which is attached such that it can be pivoted around hinge pin 41, and normally dog 42 is held at a predetermined angle and position at which sensor 43 is on by a spring and stopper omitted from the figures. However, when tension is applied to base paper 32, contacting roller 40 is pressed by the tension so that dog 42 rotates and sensor 43 turns off. By this, a fixed tension can be imparted on base paper 32, and only the required amount of base paper 32 can be peeled from protective tape 31.

Protective tape 31 from which base paper 32 has been peeled, in other words, protective tape 31 to which is affixed multiple splicing tapes 30 with their attachment surfaces facing up, is made to come across the center of splicing position LS, such that the leading end thereof is engaged with reel for indexing 46 of protective tape indexing device 36 after passing through joining device 58 which is described below. Protrusions 46a which engage with indexing holes 31a of protective tape 31 are formed at even intervals on the circumference of both edges of reel for indexing 46, and by moving a motor for indexing which is omitted from the figures and which is connected to this reel for indexing 46, protective tape 31 which is engaged by protrusions 46a is indexed and protective tape 31 is put into a collection box which is omitted from the figures.

Metal powder is embedded in splicing tape 30 and the embedded metal powder is detected by metal detection sensor 47. Metal detection sensor 47 is provided in front of splicing position LS in a position separated from splicing position LS by a fixed distance, and when the end of splicing tape 30 is detected by metal detection sensor 47, from that detection position, the splicing tape 30 is accurately positioned at splicing position LS by protective tape 31 being indexed exactly a fixed amount by the motor of protective tape indexing device 36.

As shown in FIG. 5, automatic splicing device 20 comprises first and second tape indexing devices 50 and 51, first and second component detection devices 52 and 53, first and second cutting devices 54 and 55, first and second takeup devices 56 and 57, joining device 58, and control device (refer to FIG. 1). First and second tape indexing devices 50 and 51, first and second cutting devices 54 and 55, first and second takeup devices 56 and 57, joining device 58 (excluding some part), and control device are arranged stored inside housing 21 and lid 22.

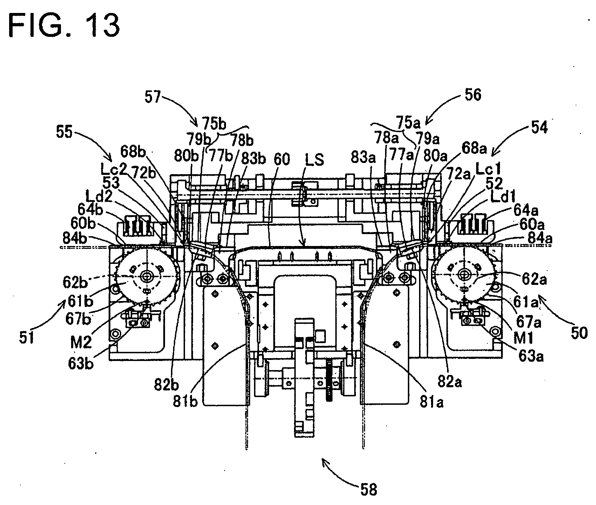

In other words, as shown in FIG. 13, at each side of housing 21 and lid 22, first and second tape indexing devices 50 and 51 are respectively arranged, and first and second cutting devices 54 and 55 are respectively arranged between first and second tape indexing devices 50 and 51 (hereafter referred to as first and second cutting positions Lc1 and Lc2). Further, first and second takeup devices 56 and 57 are respectively arranged between first and second cutting devices 54 and 55 (between hereafter referred to as first and second cutting positions Lc1 and Lc2, and splicing position LS), and joining device 58 is arranged between first and second takeup devices 56 and 57. And, first and second component detection devices 52 and 53 are arranged above first and second detection positions Ld1 and Ld2 of first and second conveyance paths 60a and 60b of first and second tape indexing devices 50 and 51 which are mentioned later.

As shown in FIG. 13, first and second tape indexing devices 50 and 51 comprise items such as first and second conveyance paths 60a and 60b provided extending horizontally towards the center from each side of housing 21, first and second sprockets 61a and 61b arranged below first and second conveyance paths 60a and 60b, first and second gear motors 62a and 62b connected to first and second sprockets 61a and 61b, first and second sprocket tooth detection devices 63a and 63b arranged adjacent to first and second sprockets 61a and 62b, and first and second tape detection devices 64a and 64b arranged above first and second conveyance paths 60a and 60b. First and second tape indexing devices 50 and 51 are configured such that first and second carrier tapes T1 and T2 are conveyed along first and second conveyance paths 60a and 60b, so that first and second cutting points Q1 and Q2 of first and second carrier tapes T1 and T2 can be positioned sequentially at first and second cutting positions Lc1 and Lc2 and splicing position LS.

First and second conveyance paths 60a and 60b have a slightly wider width than the width of first and second carrier tapes T1 and T2, and are formed in a groove in a straight line extending from first and second tape inlets 84a and 84b provided in each side of housing 21 to first and second cutting positions Lc1 and Lc2 of first and second carrier tapes T1 and T2 according to first and second cutters 68a and 68b of first and second cutting devices 54 and 55 which are described below. Further, as shown in enlarged figure A of FIG. 5 (showing only second conveyance path 60b, with conveyance path 60a being the same), first and second narrow grooves 65a and 65b are provided in first and second conveyance paths 60a and 60b such that first and second cavities Cte1 and Cte2 of first and second embossed tapes T1e and T2e stored in which are first and second components e1 and e2 can pass through.

In other words, first and second plate springs 66a and 66b are fixedly arranged at first and second cutting positions Lc1 and Lc2 in first and second narrow grooves 65a and 65b. First and second plate springs 66a and 66b are bent in a concave shape and fixedly arranged to be inclined such that they and sloping towards and diagonally above first and second cutting positions Lc1 and Lc2. First and second plate springs 66a and 66b are members which are effective when cutting and conveying first and second embossed tape T1e and T2e, with details described below.

Multiple first and second teeth 67a and 67b are formed in a circumferential direction in first and second sprockets 61a and 61b at the same pitch Ph as first and second indexing holes Hc1 and Hc2 which are formed in first and second carrier tapes T1 and T2. First and second sprockets 61a and 61b are arranged below first and second conveyance paths 60a and 60b such that first and second teeth 67a and 67b which have been rotated to the highest point among first and second teeth 67a and 67b being rotated, and first and second indexing holes Hc1 and Hc2 of first and second carrier tapes T1 and T2 which enter along first and second conveyance paths 60a and 60b, can engage with each other.

First and second gear motors 62a and 62b are, for example, stepping motors for which position control of first and second cutting points Q1 and Q2 of first and second carrier tapes T1 and T2 conveyed by connected first and second sprockets 61a and 61b is possible. First and second sprocket tooth detection devices 63a and 63b are, for example, photosensors which detect whether one of first and second teeth 67a and 67b of first and second sprockets 61a and 61b have become vertical, in other words whether first and second sprockets 61a and 61b have reached the origin position, by reading first and second marks M1 and M2 affixed to the side of first and second sprockets 61a and 61b.

First and second tape detection devices 64a and 64b are, for example, touch sensors which detect whether first and second carrier tapes T1 and T2 have been inserted into first and second tape inlets 84a and 84b provided in each side of housing 21 by contacting first and second carrier tapes T1 and T2. Here, it is also acceptable to use a photosensor instead of a touch sensor. First and second component detection devices 52 and 53 are, for example, photosensors which detect: the tape section between first and second cavities Ct1 and Ct2, and first and second cavities Ct1 Ct2 of first and second carrier tapes T1 and T2 conveyed along first and second conveyance paths 60a and 60b; and first and second components e1 and e2 in first and second cavities Ct1 and Ct2, by the change in the amount of light. Here, it is also acceptable to use a camera instead of a photosensor.

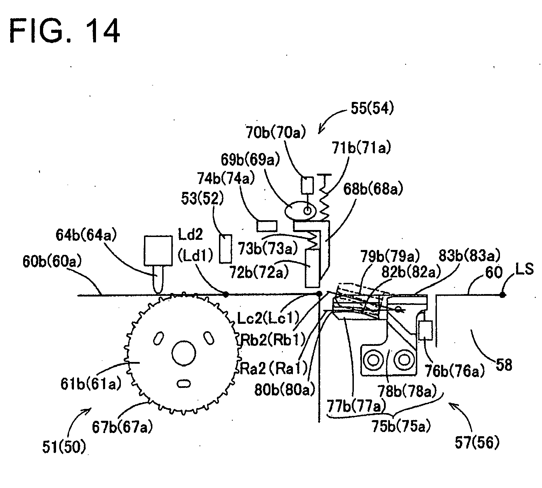

As shown in FIG. 13 and FIG. 14, first and second cutting devices 54 and 55 comprise items such as first and second cutters 68a and 68b provided at first and second cutting positions Lc1 and Lc2, first and second cams 69a and 69b which can slidably contact first and second cutters 68a and 68b, first and second gear motors 70a and 70b connected to first and second cams 68a and 68b, first and second cutters springs 71a and 71b one end of which is attached to first and second cutters 68a and 68b and the other end of which is attached to the inside of lid 22, first and second pressing members 72a and 72b provided to be contacting first and second cutters 68a and 68b, first and second pressing springs 73a and 73b one end of which is attached to first and second cutters 68a and 68b and the other end of which is attached to first and second pressing members 72a and 72b, and first and second cutter detection devices 74a and 74b arranged adjacent to first and second cutters 68a and 68b. First and second tape cutting devices 54 and 55 are capable of cutting first and second unnecessary sections Tf1 and Tf2 at first and second cutting points Q1 and Q2 of first and second carrier tapes T1 and T2.

First and second cutters 68a and 68b are single blade cutters with a width which is wider than first and second carrier tapes T1 and T2. First and second cutters 68a and 68b are attached to be movable up and down in order to cut first and second cutting points Q1 and Q2 of first and second carrier tapes T1 and T2 positioned at first and second cutting positions Lc1 and Lc2. First and second cams 69a and 69b are arranged rotatably connected to first and second gear motors 70a and 70b and are positive motion cams which slidably connect to first and second cutters 68a and 68b to move first and second cutters 68a and 68b up and down.

First and second cutter springs 71a and 71b are extension springs which bias first and second cutters 68a and 68b up so that first and second cutters 68a and 68b return to the holding position after cutting is completed. First and second pressing members 72a and 72b are plate members with a width slightly wider than the width of first and second carrier tapes T1 and T2. First and second pressing members 72a and 72b are provided to be movable up and down in order to press and fix the area around first and second cutting points Q1 and Q2 of first and second carrier tapes T1 and T2 positioned at first and second cutting positions Lc1 and Lc2.

First and second pressing springs 73a and 73b are compression springs to bias first and second pressing members 72a and 72b downwards with the lowering of first and second cutters 68a and 68b, and are springs for pressing the area around first and second cutting points Q1 and Q2 of first and second carrier tapes T1 and T2. First and second cutter detection devices 74a and 74b are, for example, photosensors which detect whether first and second cutters 68a and 68b are positioned in the cutting holding position. Here, it is also acceptable to use a touch sensor instead of a photosensor.

As shown in FIG. 13 and FIG. 14, first and second takeup devices 56 and 57 are provided between splicing position LS and first and second cutting positions Lc1 and Lc2, and are comprised of items such as first and second takeup members 75a and 75b which are made from first and second movable members 77a and 77b and first and second fixed members 78a and 78b, and first and second takeup member moving devices 76a and 76b which move first and second movable members 77a and 77b. First and second tape takeup devices 56 and 57 are configured to be capable of respectively taking up first and second unnecessary sections Tf1 and Tf2 cut from first and second carrier tapes T1 and T2.

First and second movable members 77a and 77b are rotatably attached to first and second fixed members 78a and 78b. First and second movable conveyance paths 79a and 79b which make up part of first and second conveyance paths 60a and 60b, and first and second apertures 80a and 80b for taking up first and second unnecessary sections Tf1 and Tf2 of first and second carrier tapes T1 and T2 conveyed on first and second conveyance paths 60a and 60b are formed in first and second movable members 77a and 77b. Also provided in first and second movable members 77a and 77b are first and second ducts 82a and 82b which guide taken up first and second unnecessary sections Tf1 and Tf2 into first and second disposal points 81a and 81b which are below first and second conveyance paths 60a and 60b. Further, first and second movable conveyance paths 79a and 79b, and first and second fixed conveyance paths 83a and 83b which make up part of first and second conveyance paths 60a and 60b and which are capable of forming a line, are formed in first and second fixed members 78a and 78b. Here, it is acceptable for first and second movable members 77a and 77b to be attached to first and second fixed members 78a and 78b to be movable up and down.

First and second takeup member moving devices 76a and 76b are, for example, solenoids and are connected to first and second movable members 77a and 77b such that first and second movable members 77a and 77b can be moved between: first and second conveyance positions Ra1 and Ra2 at which first and second movable conveyance paths 79a and 79b are arranged in a line with first and second conveyance paths 60a and 60b; and first and second aperture forming positions Rb1 and Rb2 which are where apertures 80a and 80b are formed in first and second conveyance paths 60a and 60b between splicing position LS and first and second cutting positions Lc1 and Lc2.

Joining device 58 is provided between first cutting device 54 and second cutting device 55 and formed therein is conveyance path 60 which is part of first and second conveyance paths 60a and 60b. Joining device 58 is capable of conveying along conveyance path 60 and connecting first and second carrier tapes T1 and T2 of which first and second cutting points Q1 and Q2 are aligned at splicing position LS in the center of conveyance path 60.

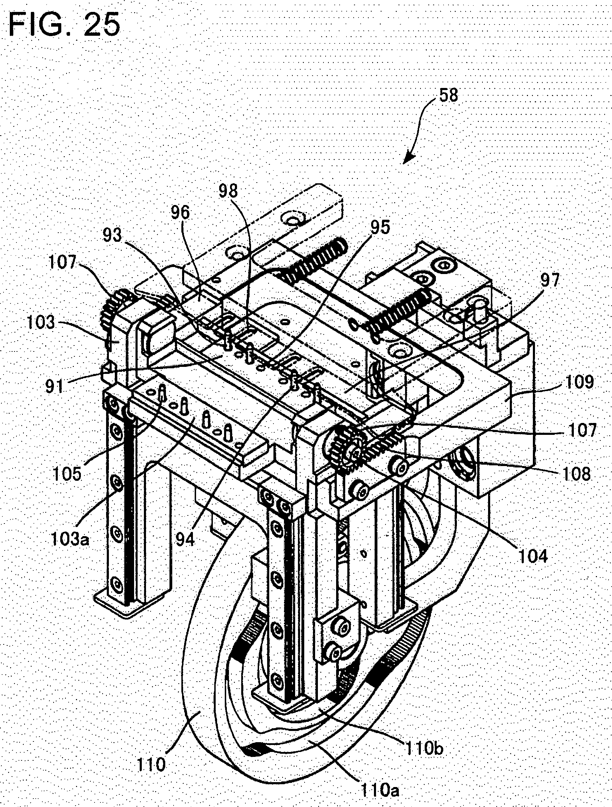

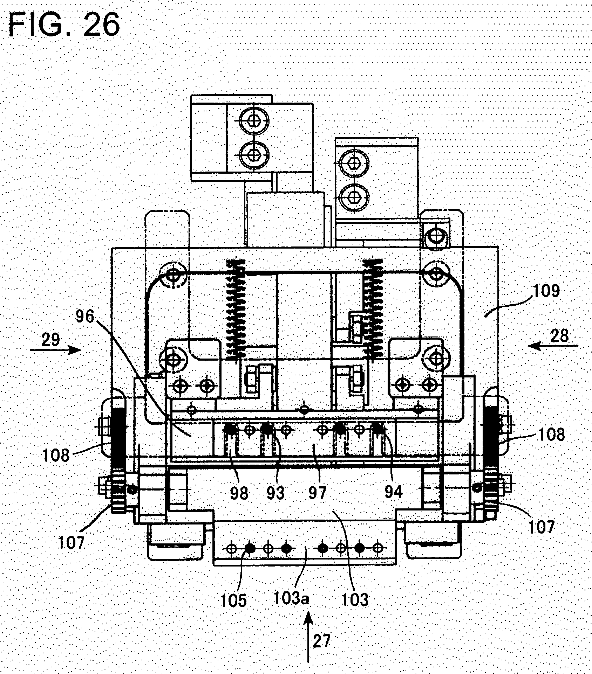

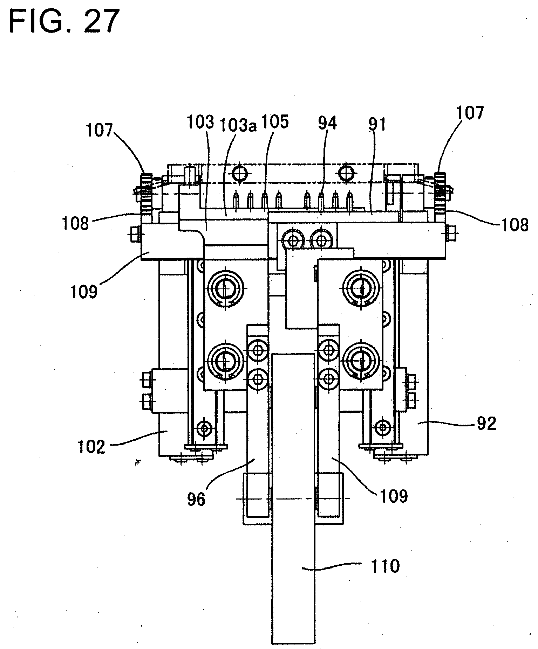

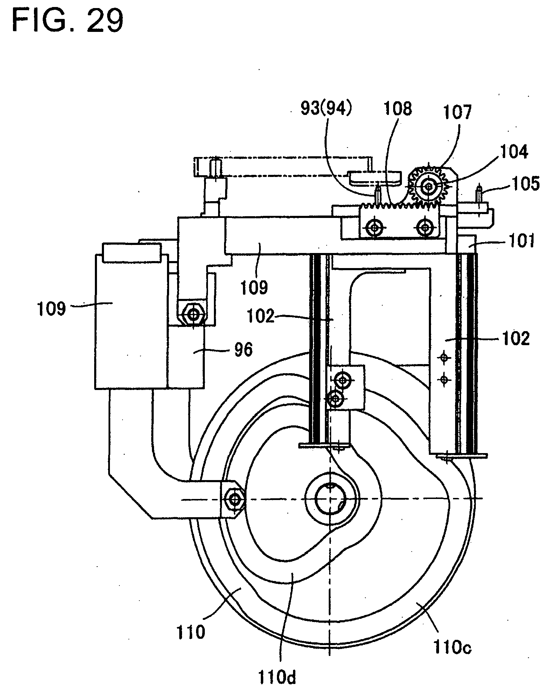

Next, the configuration of joining device 58 is described based on FIG. 25 to FIG. 29. Joining device 58 has items such as first raising/lowering platform 91, retainer plate 97, second raising/lowering platform 101, and rotating platform 103. Legs 92 of first raising/lowering platform 91 are guided and supported on housing 21 capable of being raised/lowered. Two each of first positioning pins 93 and 94 capable of engaging with each indexing hole Hc of two carrier tapes T1 and T2 and positioning holes 30a1 formed in splicing tape 30a are formed along the indexing direction of carrier tapes T1 and T2 on both sides of first raising/lowering platform 91 with the engagement position (alignment position) of the two carrier tapes T1 and T2 at the center. Each pitch of these two sets of first positioning pins 93 and 94 is fixed as twice pitch P of indexing holes Hc on carrier tapes T1 and T2.

Also, pin holes 95 are formed on raising/lowering platform 91 between each first positioning pins 93 and 94, and second positioning pins on rotating platform described below are capable of being inserted into these pin holes 95. Also, moving platform 96 is guided and supported capable of being moved on housing 21 is a horizontal direction perpendicular to the lengthwise direction of carrier tapes T1 and T2, and retainer plate 97 is attached to this moving platform 96 above first positioning pins 93 and 94. U-shaped grooves 98 which can house first positioning pins 93 and 94 are formed in an end of retainer plate 97, and retainer plate 97 can be advanced and retracted between a retract point in which grooves 98 are separated from first positioning pins 93 and 94, and an advance point at which grooves 98 house first positioning pins 93 and 94.

Further, legs 102 of second raising/lowering platform 101 are guided and supported on housing 21 capable of being raised/lowered. Rotating platform 103 is attached at both ends on second raising/lowering platform 101 capable of being rotated 180 degrees with pivot axis 104 which is parallel to the lengthwise direction of carrier tapes T1 and T2 as the rotational center. Pressing plate 103a is provided on rotating platform 103a in a position offset from the rotational center, and multiple second positioning pins 105 and pin holes 106 are provided in this pressing plate 103a. Second positioning pins 105 are arranged in positions corresponding to the space between first positioning pins 93 and 94 provided on first raising/lowering platform 91 described above, such that they are capable of being inserted into pin holes 95 provided in first raising/lowering platform 91. Also, pin holes 106 are arranged in positions corresponding to each space between second positioning pins 105, such that first positioning pins 93 and 94 provided in first raising/lowering platform 91 are capable of being inserted into them.

By the 180 degree rotation of rotating platform 103, second positioning pins 105 engage with positioning holes 30a1 of splicing tape 30a and indexing holes Hc of the two carrier tapes T1 and T2 positioned at splicing position LS, such that a fixed three way positional relationship is maintained between the two carrier tapes T1 and T2 and splicing tape 30 used to connect those. Pinion 107 is attached to pivot axis 104 of rotating platform 103, and rack 108 which engages with this pinion 107 is attached to movable platform 109 capable of being moved in a direction perpendicular to the lengthwise direction of carrier tapes T1 and T2. By this, when moving platform 109 is moved, by the rack and pinion mechanism formed from pinion 107 and rack 108, rotating platform 103 is rotated.

Cam drum 110 is attached to housing 21 capable of being rotated around an axis line parallel to the rotational center of rotating platform 103, such that it is rotated slowly in a fixed direction by a moving motor which is omitted from the figures. Two each on the inside and outside cam grooves 110a, 110b, 110c, and 110d are formed with a no-edge form in the circumferential direction of each on both surfaces of cam drum 110. First follower roller omitted from the figures attached to leg 92 of first raising/lowering platform 91 is engaged with first cam groove 110a. Second follower roller omitted from the figures attached to moving platform 96 connected to retainer plate 97 is engaged with second cam groove 110b. Third follower roller omitted from the figures attached to leg 102 of first raising/lowering platform 101 is engaged with third cam groove 110c. Fourth follower roller omitted from the figures attached to connecting member 112 connected to moving platform 107 is engaged with fourth cam groove 110d.

By this, when cam drum 110 is rotated, respective raising/lowering operation of first and second raising/lowering platforms 91 and 101, advancing/retracting operation of retainer plate 97, and rotating operation of rotating platform 103 are performed in series via first to fourth follower rollers respectively engaging with first to fourth cam grooves 110a to 110d, such that first and second raising/lowering platforms 91 and 101, retainer plate 97, and rotating platform 103 return to their origin positions with one rotation of cam drum 110.

Next, the splicing operation of the above embodiment is described. When the remaining quantity of components e held in first carrier tape T1 wound around reel 12 attached to tape feeder 10 becomes few, splicing processing to connect the leading end of second carrier tape T2 wound around another reel in which is stored the same type of component e with the tail end of carrier tape T1 using splicing tape 30 is performed. The component is replenished by this splicing such that component supply from tape feeder 10 can be continued.

For this splicing, normally a check as to whether carrier tape in which the correct component is stored has been connected, what is known as splicing verification, is performed. With splicing verification, the barcode affixed to the old reel is read with a barcode reader and the serial ID of the component stored in the old reel is transmitted to the management computer. Next, the barcode affixed to the new reel is read by a barcode reader and the serial ID of the component stored in the new reel is transmitted to the management computer.

Data related to components is saved in the database of the management computer by each serial ID, so a check can be performed from the read serial IDs as to whether the components stored in the two carrier tapes T1 and T2 are the same type. If the components are different, the operator is notified by a verification error being displayed on the operation panel and the operator performs splicing again based on this. When this kind of splicing verification is completed, each end of the two carrier tapes T1 and T2 is cut using scissors. Here, normally provided in the end of each carrier tape T1 and T2 is a section of several cm of empty cavities in which components are not stored, and this section is cut by the operator. In this case, the cut surfaces, as described clearly hereafter, are not the surfaces of the two carrier tapes T1 and T2 to be aligned, therefore it is not required for them to be especially accurate.

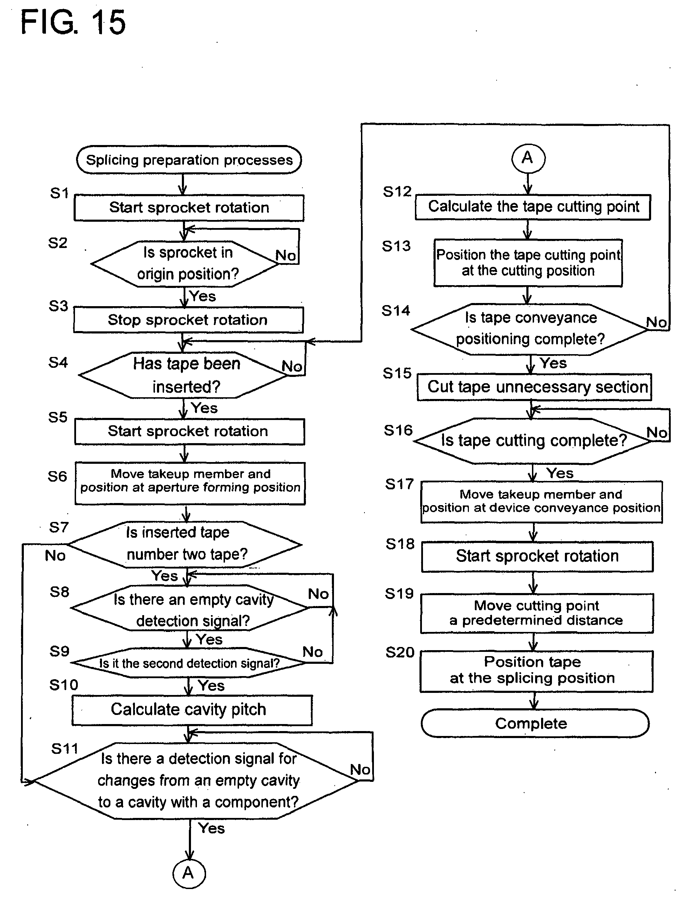

First, among the operations of automatic splicing device 20, splicing preparation processes are described with reference to the flowchart in FIG. 15. In the following description, descriptions are given for when the operator has set first carrier tape T1 (the type shown in FIG. 11 [FIG. 12 (A)]) into automatic splicing device 20 after setting second carrier tape T2 (the type shown in FIG. 11 [FIG. 12 (A)]), however, the same applies when second carrier tape T2 is set after setting first carrier tape T1.

By the power to automatic splicing device 20 being turned on by the operator, control device starts rotating first and second sprockets 61a and 61b (step S1), and judges as to whether a detection signal is received from first and second sprocket tooth detection devices 63a and 63b, in other words whether first and second sprockets 61a and 61b are at the origin position (step S2). Next, if a detection signal is received from first and second sprocket tooth detection devices 63a and 63b, rotation of first and second sprockets 61a and 61b is stopped (step S3).

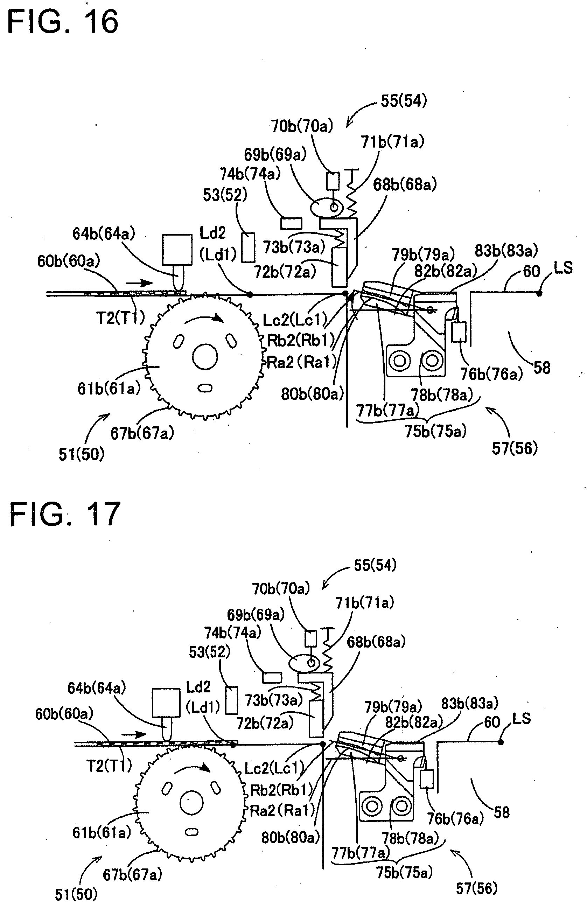

Control device judges whether a detection signal has been received from second tape detection device 64b, in other words, as to whether the leading end of second tape T2 has been inserted into second conveyance path 60b from second tape inlet 84b (step S4) . Then, if a detection signal is received from second tape detection device 64b, as shown in FIG. 16, rotation of second sprocket 61b is started (step S5), and second movable member 77b of second takeup member 75b is moved up and positioned (step S6) at second aperture forming position Rb2.

Control device judges (step S7) whether the inserted tape is second carrier tape T2, and in this case a detection signal has been received from second detection device 64b, so it judges that the inserted tape is second carrier tape T2 and then judges (step S8) whether a detection signal for an empty second cavity Ct2 without a second component e2 in second carrier tape T2 is received from second component detection device 53. Then, as shown in FIG. 17, if an empty second cavity Ct2 is detected, a judgment (step S9) is performed as to whether that detection is the second detection, and if it is not the second detection, the process returns to step S8 and a judgment is performed as to whether the next empty second cavity Ct2 has been detected.

Control device, in step S9, in the case that the detection of the empty second cavity Ct2 is the second detection, calculates fixed pitch Pc between second cavities Ct2 based on the detected first and second cavities Ct2 (step S10 applies to "pitch calculation means" for this invention). Then, a judgment (step S11) is performed as to whether a detection signal detecting the change from an empty second cavity Ct2 to a second cavity Ct2 with a second component e2 is received from second component detection device 53.

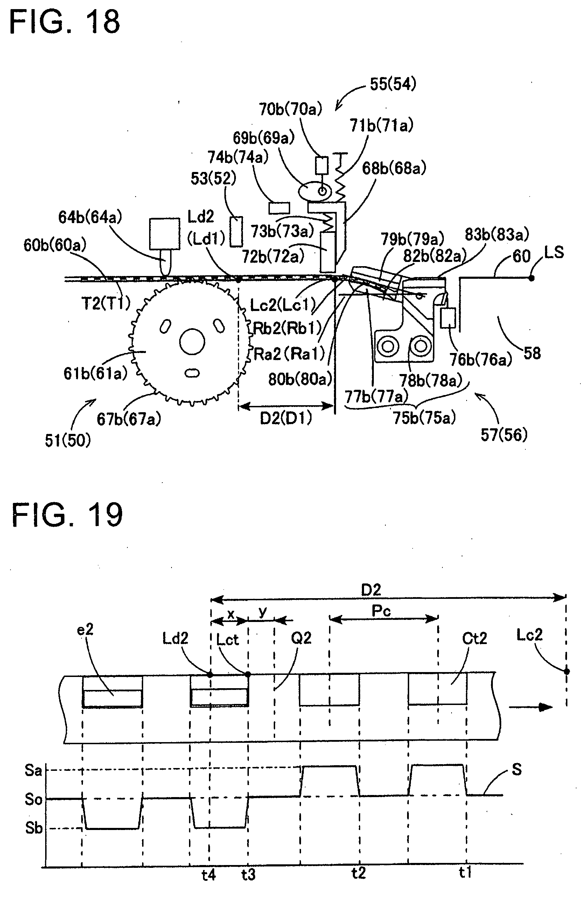

Control device, if it detects a change to a second cavity Ct2 with a second component e2, calculates second cutting point Q2 of second tape T2 from the second distance D2 between the already known second detection position Ld2 and second cutting position Lc2, and fixed pitch Pc between second cavities Ct2 calculated in step S10 (step S12 applies to "second cut point calculation means" for this invention) . Then, as shown in FIG. 18, second tape T2 is moved second distance D2, second unnecessary section Tf2 is taken up inside second takeup member 75b from second aperture 80b, and the conveyance position of second cutting point Q2 is decided at second cutting position Lc2.

Next, an example of processing from the above step S8 to step S13 is described in detail. As shown in FIG. 19, for detection signal (light amount) S from second component detection device 53, if So is taken to indicate the tape section between second cavities Ct2 of second tape T2, Sa is indicated for empty second cavities Ct2 without a second component e2 because the amount of light passing through increases, and Sb is indicated for second cavities Ct2 with a second component e2 because the amount of light passing through decreases.

Here, point in time t1 at which detection signal S arises when there is a change from the tape section to the first empty second cavity Ct2, and point in time t2 at which detection signal S arises when there is a change from the tape section to the second empty second cavity Ct2 are detected, and the pulse quantity of second gear motor 62b for second sprocket 61b is counted between point in time t1 and point in time t2. Then, by calculating a second tape T2 indexing amount based on this pulse count, fixed pitch Pc between second cavities Ct2 can be calculated.

Next, when there is a change from empty second cavity Ct2 to second cavity Ct2 with a second component e2, the pulse quantity of second gear motor 62b for second sprocket 61b is counted between current point in time t4 and point in time t3 at which detection signal S from that time arose. Then, by calculating a second tape T2 indexing amount based on this pulse count, the distance x between second detection position Ld2 and right edge position Lct as shown in the figure of second cavity Ct2 with a second component e2 can be calculated. Also, from fixed pitch Pc between second cavities Ct2, the center position of the tape section between second cavities Ct2 and right edge position Lct as shown in the figure of second cavity Ct2 with a second component e2, in other words distance y to second cutting point Q2, can be calculated.

Then, by conveying second tape T2 just the distance D2 - x - y calculated by subtracting the above distances x and y from second distance D2 between already known second detection position Ld2 and second cutting position Lc2, the conveyance position of second cutting point Q2 can be decided at second cutting position Lc2. Alternatively, by conveying second tape T2 just second distance D2 after reverse conveying second tape T2 just the above distances x and y, the conveyance position of second cutting point Q2 can be decided at second cutting position Lc2.

Described above was the situation for the type of tape shown in FIG. 11 (FIG. 12[A]) as second carrier tape T2, but for the types of tapes shown in FIG. 12 (B) and (C), first and second cutting points Q1 and Q2 must be calculated so that the pitch after splicing between first indexing holes Hc1 of first carrier tape T1 and second indexing holes Hc2 of second carrier tape T2 becomes fixed pitch Ph. In this case, the deviation amount from the origin position of first and second sprockets 61a and 61b when changing from empty first and second cavities Ct1 and Ct2 to first and second cavities Ct1 and Ct2 with first and second components e1 and e2, is calculated from the count of the pulse quantity of second gear motor 62b and reading of first and second marks M1 and M2 by first and second sprocket tooth detection devices 63a and 63b. Then, based on this deviation amount and the already known distance between second detection position Ld2 and the origin position of first and second sprockets 61a and 61b, first and second cutting points Q1 and Q2 are calculated so that the pitch after splicing between first indexing holes Hc1 of first carrier tape T1 and second indexing holes Hc2 of second carrier tape T2 becomes fixed pitch Ph.

Control device judges whether deciding the conveyance positions of second carrier tape T2 and first carrier tape T1 has been completed (step S14), and in this case, because only deciding the conveyance position of second carrier tape T2 has been completed, processing returns to step S4 and it judges whether a detection signal has been received from first tape detection device 64a, in other words, as to whether the tail end of first tape T1 has been inserted into first conveyance path 60a from first tape inlet 84a. Then, if a detection signal is received from first tape detection device 64a, rotation of first sprocket 61a is started (step S5), and first moving member 77a of first takeup member 75a is moved up and positioned (step S6) at first aperture forming position Rb1.

Control device judges (step S7) whether the inserted tape is second carrier tape T2, and in this case a detection signal has been received from first detection device 64a, so it judges that the inserted tape is first carrier tape T1, and because fixed pitch Pc between first cavities Ct1 is the same as the already calculated fixed pitch Pc between second cavities Ct2, it judges (step S11) whether a detection signal detecting the change from an empty first cavity Ct1 to a first cavity Ct1 with a first component e1 is received from first component detection device 52.

Control device, if it detects a change to a first cavity Ct1 with a first component e, calculates first cutting point Q1 of first carrier tape T1 from the first distance D1 between the already known first detection position Lc1 and first cutting position Ld1, and fixed pitch Pc between first cavities Ct1. Then, first carrier tape T1 is moved first distance D1, first unnecessary section Tf1 is taken up inside first takeup member 75a from first aperture 80a, and the conveyance position of first cutting point Q1 is decided at first cutting position Lc1.

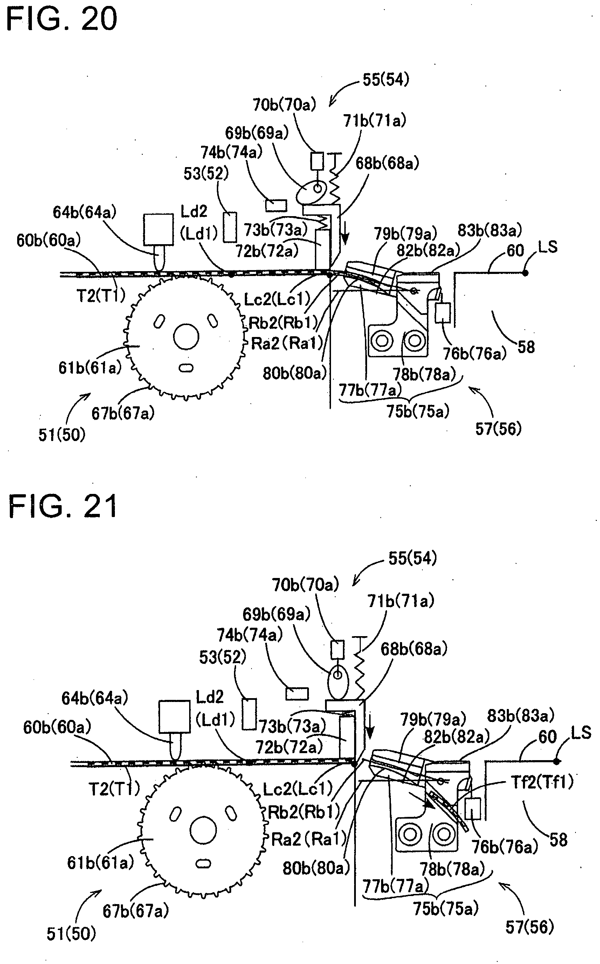

Control device judges whether deciding the conveyance positions of second carrier tape T2 and first carrier tape T1 has been completed (step S14), and in this case, because deciding the conveyance position of second carrier tape T2 and first carrier tape T1 has been completed, as shown in FIG. 20, first and second cutters 68a and 68b are respectively lowered along with first and second pressing members 72a and 72b, and the area around first and second cutting points Q1 and Q2 of first and second carrier tapes T1 and T2 positioned at first and second cutting positions Lc1 and Lc2 is pressed and fixed using first and second pressing members 72a and 72b. Then, as shown in FIG. 21, first and second cutters 68a and 68b are respectively lowered further and first and second cutting points Q1 and Q2 of first and second carrier tapes T1 and T2 are cut (step S15). Cut first and second unnecessary sections Tf1 and Tf2 of first and second carrier tapes T1 and T2 are guided by first and second ducts 82a 82b and discarded into first and second disposal points 81a and 81b.

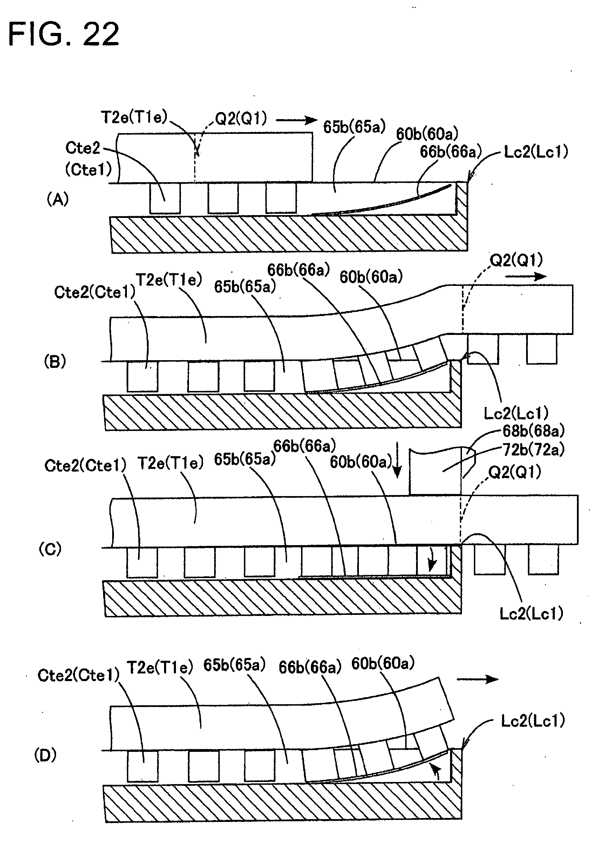

Described above was the situation for the type of tape shown in FIG. 11 (FIG. 12[A]) as first and second carrier tapes T1 and T2, so described below is the operation when cutting first and second embossed carrier tapes T1e and T2e shown in FIG. (D). As shown in FIG. 22, when first and second embossed carrier tapes T1e and T2e are conveyed along first and second conveyance paths 60a and 60b, first and second cavities Cte1 and Cte2 are conveyed inside first and second narrow grooves 65a and 65b (refer to FIG. 22[A]). Then, when first and second embossed carrier tapes T1e and T2e get close to first and second cutting positions Lc1 and Lc2, first and second cavities Cte1 and Cte2 ride on first and second plate springs 66a and 66b, go past first and second cutting positions Lc1 and Lc2, and first and second cutting points Q1 and Q2 are positioned at first and second cutting positions Lc1 and Lc2 (refer to FIG. 22[B]).

Then, when first and second cutters 68a and 68b are respectively lowered along with first and second pressing members 72a and 72b, first and second pressing members 72a and 72b press and fix the area around first and second cutting points Q1 and Q2 of first and second embossed carrier tapes T1e and T2e positioned at first and second cutting positions Lc1 and Lc2. At this time, first and second cavities Cte1 and Cte2 are elastically deformed under first and second plate springs 66a and 66b and stored in first and second narrow grooves 65a and 65b (refer to FIG. 22[C]). By this, because first and second cutting points Q1 and Q2 of first and second embossed carrier tapes T1e and T2e are positioned with high accuracy at first and second cutting positions Lc1 and Lc2, the cutting accuracy of first and second embossed carrier tapes T1e and T2e can be improved.

Then, when first and second cutters 68a and 68b are respectively raised along with first and second pressing members 72a and 72b, first and second plate springs 66a and 66b return to their original position and first and second cavities Cte1 and Cte2 around first and second cutting positions Lc1 and Lc2 are raised above first and second narrow grooves 65a and 65b (refer to FIG. 22[D]). By this, first and second cavities Cte1 and Cte2 can ride on first and second plate springs 66a and 66b to go past first and second cutting positions Lc1 and Lc2, so conveyance of first and second embossed carrier tapes T1e and T2e can be performed smoothly.

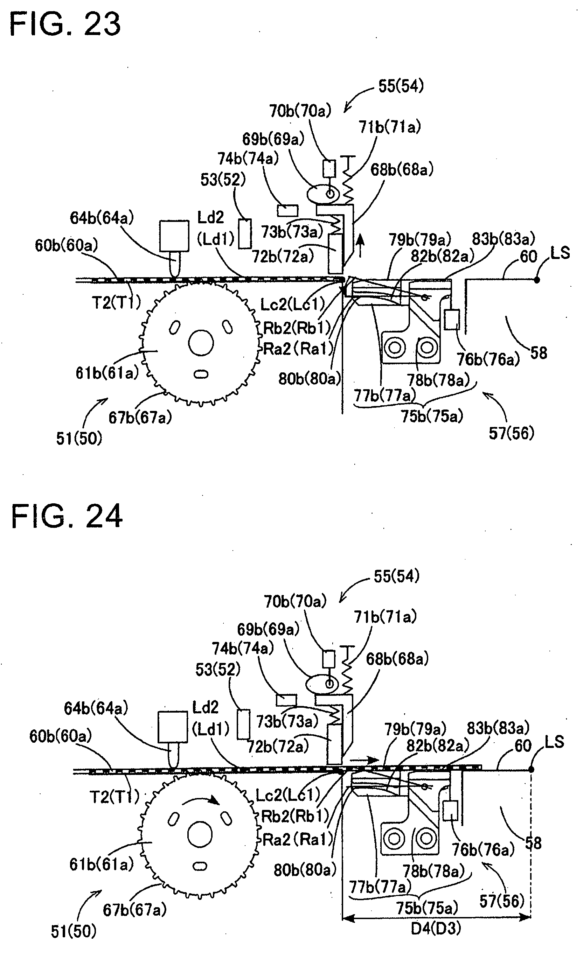

Control device judges whether a detection signal is received from first and second cutter detection devices 74a and 74b, in other words, judges whether cutting of first and second cutting points Q1 and Q2 of first and second carrier tapes T1 and T2 by first and second cutters 68a and 68b has been completed (step S16). Then, when a detection signal is received from first and second cutter detection devices 74a and 74b, as shown in FIG. 23, first and second movable members 77a and 77b of first and second takeup members 75a and 75b are moved down and respectively positioned (step S17) at first and second conveyance positions Ra1 and Ra2. Then, as shown in FIG. 24, rotation is started (step S18) respectively of first and second sprockets 61a and 61b, and first and second cutting points Q1 and Q2 of first and second carrier tapes T1 and T2 are respectively moved (step S19) by just third and fourth distances D3 and D4 between splicing position LS and first and second cutting positions Lc1 and Lc2. Then, rotation is stopped respectively of first and second sprockets 61a and 61b and the conveyance position of first and second cutting points Q1 and Q2 is decided at splicing position LS.

By this, the ends of first and second carrier tapes T1 and T2 inserted into first and second tape inlets 84a and 84b are aligned with each other at splicing position LS without any deviation in pitch arising. By the above, splicing preparation processes are complete, so next the splicing process is performed. The three-layer structure of base paper 32, splicing tape 30, and protective tape 31 wound around supply reel 33 is pulled out from supply reel 33 and base paper 32 is peeled and indexed by base paper indexing device 35. On the other hand, protective tape 31 affixed to splicing tape 30 is indexed by protective tape indexing device 36 and conveyed to splicing position LS.

When one of the two pieces making up one set of splicing tape 30a affixed to protective tape 31, in other words, splicing tape 30a formed with positioning holes 30a1, is detected by metal detection sensor 47, protective tape 31 is indexed from that detection position a fixed amount S1 by protective tape indexing device 36. By this, splicing tape 30a is positioned in a position capable of being engaged with first positioning pins 93 and 94 of joining device 58 provided at splicing position LS, and in that state, the respective ends of first and second carrier tapes T1 and T2 are on standby until positioned at splicing position LS.

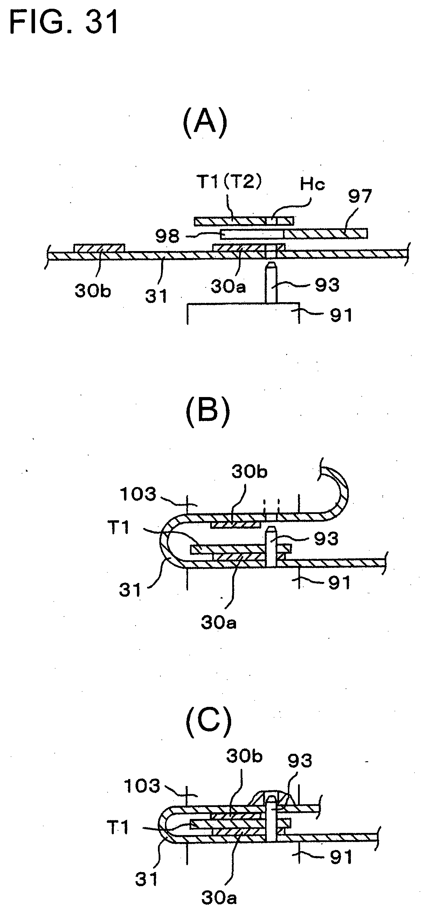

When first and second carrier tapes T1 and T2 are respectively positioned at predetermined points, cam drum 110 is rotated by a moving motor omitted from the figures. By the rotation of cam drum 110, first, first raising/lowering platform 91 is raised via first follower roller omitted from the figures which engages with first cam groove 110a. By the raising of first raising/lowering platform 91, first positioning pins 93 and 94 respectively engage with each indexing hole Hc of the two carrier tapes T1 and T2, and positioning holes 30a1 of splicing tape 30a. Here, between splicing tape 30a and carrier tapes T1 and T2, as shown in FIG. 31 (A), because retainer plate 97 is present, carrier tapes T1 and T2 do not get attached to splicing tape 30a. By this, a fixed three-way positional relationship is maintained between the two carrier tapes T1 and T2 and splicing tape 30a which is to connect them.

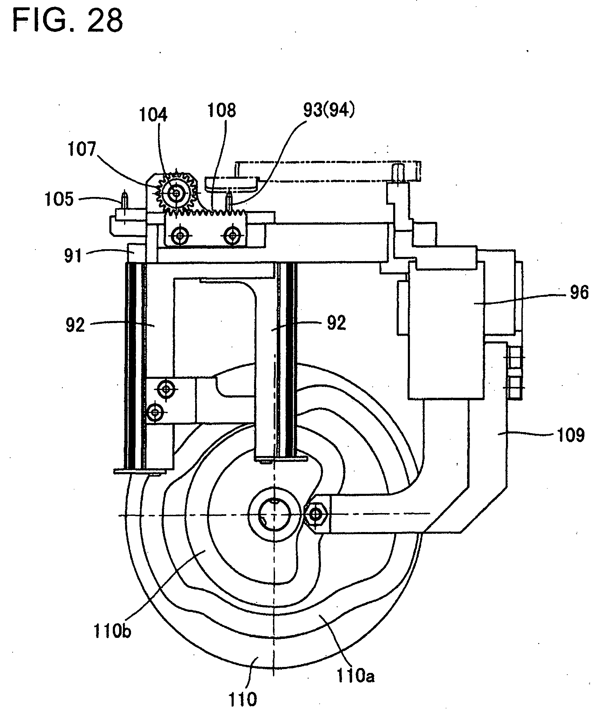

Next, via second follower roller omitted from the figures engaging with second cam groove 110b, moving platform 96 is moved in a horizontal direction, and retainer plate 97 present between splicing tape 30a and carrier tapes T1 and T2 is retracted with respect to first raising/lowering platform 91, such that splicing tape 30a and carrier tapes T1 and T2 can be connected. Next, via third follower roller omitted from the figures which engages with third cam groove 110c, moving platform 109 is moved horizontally, and rotating platform 103 is rotated in the clockwise direction of FIG. 28 by the horizontal movement of this moving platform 109 by rack and pinion mechanism (107 and 108) . By the rotation of this rotating platform 103, as shown in FIG. 31 (B), protective tape 31 engaged with second positioning pins 105 is folded, and the other splicing tape (30b) of the one set made from two pieces is flipped so that the attachment surface is facing down in a position below carrier tapes T1 and T2. In other words, protective tape 31 is folded to sandwich carrier tapes T1 and T2, and one splicing tape 30a is positioned below carrier tapes T1 and T2, and the other splicing tape 30b is positioned above carrier tapes T1 and T2. Here, the motor of protective tape indexing device 36 is reverse rotated, so slack is provided to protective tape 31 to allow protective tape 31 to be folded.

Continuing, second raising/lowering platform 101 is lowered via fourth follower roller omitted from the figures which engages with fourth cam groove 110d. When second raising/lowering platform 101 is lowered, as shown in FIG. 31 (C), second positioning pins 105 are engaged from the reverse side of protective tape 31 with positioning holes 31b of protective tape 31, indexing holes Hc of carrier tapes T1 and T2, and positioning holes 30a1 of splicing tape 30a. Further, by the lowering of second raising/lowering platform 101, with carrier tapes T1 and T2 sandwiched, folded protective tape 31 is pressed between pressing plate 103a of rotating platform 103 and first raising/lowering platform 91. By this pressing, one of splicing tape 30a affixed to protective tape 31 is attached to the lower surface (bottom surface) of carrier tapes T1 and T2 straddling thereof, and the other splicing tape 30b is attached to each cover tape Tt on the upper surface of carrier tapes T1 and T2 straddling thereof, such that the tail end of first carrier tape T1 and the leading end of second carrier tape Ts2 are connected to each other. This pressing state is held for a fixed time (several seconds).

Because the connection of the two carrier tapes T1 and T2 using splicing tape 30 is performed in a state in which relative deviation is limited by carrier tapes T1 and T2 and splicing tapes 30a and 30b being held by first and second positioning pins 93, 94, and 105, the two carrier tapes T1 and T2 can be joined accurately without any pitch deviation arising. The above joining of the two carrier tapes T1 and T2 using splicing tape 30 is completed by the approximately 180 degree rotation of cam drum 110, and each configuration member returns to its original position through the reverse operation to the above by the rotation through the remaining 180 degrees.

In other words, first, along with the second raising/lowering platform 101 being raised, rotating platform 103 being raised with respect to the first raising/lowering platform 91, and the pressing of folded protective tape 31 being released, the second positioning pins 105 are separated from positioning holes 30a1 of splicing tape 30a and each indexing hole Hc of first and second carrier tapes T1 and T2. Here, because the adhesion with respect to carrier tapes T1 and T2 of splicing tape 30 is high, protective tape 31 is easily separated from splicing tape 30 thanks to the spring return power of protective tape 31 due to the release of the pressing of protective tape 31, and splicing tape 30 does not get peeled from carrier tapes T1 and T2.

Continuing, along with rotating platform 103 being rotated in the counterclockwise direction of FIG. 28 via the rack and pinion mechanism (108 and 107), protective tape indexing motor 36 is rotated in the normal direction and the slack in protective tape 31 is eliminated. Then, along with retainer plate 97 being advanced, first raising/lowering platform 91 is lowered, and first positioning pins 93 and 94 are separated from positioning holes 30a1 of splicing tape 30a and each indexing hole Hc of the two carrier tapes T1 and T2. On the other hand, at base paper indexing device 35, the motor is driven, tension is applied to base paper 32, and just the required amount of base paper 32 is peeled. In this manner, the joining of the tail end of first carrier tape T1 and the leading end of second carrier tape T2 is completed.

When the two carrier tapes T1 and T2 are joined to each other using splicing tape 30, lid 22 of splicing device 20 is opened, and spliced first and second carrier tapes T1 and T2 are removed from splicing device 20. Then, reel 12 wound with second carrier tape T2 is set on tape feeder 10, and splicing processing is completed. By this, components are replenished to tape feeder 10, and component mounting work can be performed continuously at the component mounter without stopping the machine. Because metal powder is embedded in splicing tape 30 connected to carrier tapes T1 and T2, the splicing position can be detected easily by providing a metal detection sensor on tape feeder 10.

As described above, according to the present embodiment of the automatic splicing device, control device moves and positions first and second takeup members 75a and 75b at first and second aperture forming positions Rb1 and Rb2 until the first and second cutting points Q1 and Q2 of first and second tapes T1 and T2 are positioned at first and second cutting positions Lc1 and Lc2. By doing this, first and second unnecessary sections Tf1 and Tf2 from first and second tapes T1 and T2 can be processed by reliably being taken into first and second apertures 80a and 80b of first and second takeup members 75a and 75b. Then, after cutting first and second unnecessary sections Tf1 and Tf2, first and second takeup members 75a and 75b are moved to first and second conveyance positions Ra1 and Ra2. By doing this, first and second tapes T1 and T2 can be smoothly conveyed along first and second movable conveyance paths 79a and 79b of first and second takeup members 75a and 75b to splicing position Ls.

As described above, according to the automatic splicing device of the embodiment, control device, based on first and second component presence signals, respectively calculates first and second cutting points Q1 and Q2 of first and second tapes T1 and T2 from predetermined pitch Pc of first and second cavities Ct1 and Ct2, and first and second distances D1 and D2 between first and second detection positions Ld1 and Ld2 and first and second cutting positions Lc1 and Lc2. By this, cutting points can be specified even when tapes have different pitches between cavities, and the tapes can be spliced reliably.

Also, control device moves first and second cutting points Q1 and Q2 third and fourth distances D3 and D4 which are between first and second cutting positions Lc1 and Lc2 and splicing position Ls such that first and second cutting points Q1 and Q2 are decided at splicing position Ls. By this, first cutting point Q1 and second cutting point Q2 can be reliably matched, and the splicing accuracy of first and second tapes T1 and T2 can be improved.

Also, first and second pressing members 36a and 36b press and fix the area around first and second cutting points Q1 and Q2 of first and second tapes T1 and T2 respectively positioned at first and second cutting positions Lc1 and Lc2. By this, because the deviation of first and second tapes T1 and T2 when first and second cutting points Q1 and Q2 of first and second tapes T1 and T2 are cut by first and second cutters 32a and 36b can be prevented, the cutting accuracy of first and second tapes T1 and T2 can be improved.

### Industrial Applicability

This invention of an automatic splicing device is applicable for automatically connecting the tail end of first carrier tape number wound around first reel on a feeder equipped in a component supply device of a component mounter to the leading end of second carrier tape wound around second reel which is to be exchanged.

## Claims

1. An automatic splicing device (20) which connects a first tape (T1) and a second tape (T2) provided with cavities (Ct1, Ct2) for storing components (e1, e2) and indexing holes (Hc1, Hc2) at fixed intervals using splicing tape (30), comprising:
first and second cutting devices (54, 55) for respectively cutting at first and second cutting positions (Lc1, Lc2) the respective unnecessary sections at the tail end of the first tape (T1) and the leading end of the second tape (T2);
first and second tape indexing devices (50, 51) for conveying the first and second tapes (T1, T2) respectively along first and second conveyance paths (60a, 60b) and positioning the cutting points (Q1, Q2) of the first and second tapes (T1, T2) in order at the number and second cutting positions (Lc1, Lc2) and the splicing position (LS);
first and second detection devices (52, 53) for detecting respectively the first and second cavities (Ct1, Ct2) of the first and second tapes (T1, T2) conveyed along the first and second conveyance paths (60a, 60b), and the first and second components (e1, e2) stored in the first and second cavities (Ct1, Ct2), at first and second detection positions (Ld1, Ld2) provided respectively in the first and second conveyance paths (60a, 60b);
a control device for controlling each operation of the first and second tape indexing devices (50, 51), the first and second cutting devices (54, 55) and a joining device (58);
**characterized in that** the control device has:
a pitch calculating means (S10) for calculating the predetermined pitch between the first and second cavities (Ct1, Ct2) based on at least one of the first and second cavities (Ct1, Ct2) detected at at least one of the first and second detection devices (52, 53);
a first and second cutting point calculating device for calculating respectively the first and second cutting points (Q1, Q2) of the first and second tapes (T1, T2) from first distance (D1) between the first detection position (Ld1) and the first cutting position (Lc1), and second distance (D2) between the second detection position (Ld2) and the second cutting position (Lc2), and the predetermined pitch (Pc) calculated by the pitch calculating means (S10), based on a first and second component presence signal output after the first and second detections devices (52, 53) detect a switch from first and second cavities (Ct1, Ct2) without the first and second components (e1, e2) to first and second cavities (Ct1, Ct2) with the first and second components (e1, e2); and
a first and second cutting position deciding means (S14) which control the first and second tape indexing devices (50, 51) and move the first and second tapes (T1, T2) first and second distances (D1, D2) after the first and second component presence signal is output to respectively decides the conveyance positions of the first and second cutting points (Q1, Q2) at the first and second cutting positions (Lc1, Lc2).

2. The automatic splicing device (20) according to claim 1,
wherein the control device uses a first and second splicing positioning means wherein, when the first and second cutting points (Q1, Q2) positioned at the first and second cutting positions (Lc1, Lc2) are cut by the first and second cutting devices (54, 55), the first and second tape indexing devices (50, 51) are controlled so that the first and second cutting points (Q1, Q2) are moved third and fourth distances (D3, D4) between the first and second cutting points (Q1, Q2) and the splicing position (LS) so that the first and the second cutting points (Q1, Q2) are positioned at the splicing position (LS).

3. An automatic splicing device (20) according to claim 1 or 2,
wherein the first and second cutting devices (54, 55) comprise: first and second cutters (68a, 68b) which cut the first and second cutting points (Q1, Q2) positioned at the first and second cutting positions (Lc1, Lc2) of the first and second tapes (T1, T2) and which are attached to be movable up and down; and
first and second pressing members (36a, 36b) provided adjacent to the first and second cutters (68a, 68b) so that they can move up and down, which press and fix the area around the first and second cutting points (Q1, Q2) of the first and second tapes (T1, T2) respectively positioned at the first and second cutting positions (Lc1, Lc2).

## Patentansprüche

1. Automatische Spleißvorrichtung (20), die ein erstes Band (T1) und ein zweites Band (T2), die mit Hohlräumen (Ct1, Ct2) zum Speichern von Bauteilen (e1, e2) und Transportlöchern (Hc1, Hc2) in festen Intervallen versehen sind, unter Verwendung eines Spleiß-Bandes (30) verbindet, wobei sie umfasst:
eine erste und eine zweite Schneidvorrichtung (54, 55), die an einer ersten bzw. einer zweiten Schneid-Position (Lc1, Lc2) die jeweils nicht benötigten Teilabschnitte an dem hinteren Ende des ersten Bandes (T1) und dem vorderen Ende des zweiten Bandes (T2) schneiden;
eine erste und eine zweite Band-Transportvorrichtung (50, 51), die das erste und das zweite Band (T1, T2) auf einem ersten bzw. einem zweiten Transportweg (60a, 60b) transportieren und die Schneidpunkte (Q1, Q2) des ersten und des zweiten Bandes (T1, T2) der Reihe nach in der Anzahl sowie zweiten Schneid-Positionen (Lc1, Lc2) und der Spleiß-Position platzieren;
eine erste und eine zweite Erfassungsvorrichtung (52, 53), die die ersten bzw. die zweiten Hohlräume (Ct1, Ct2) des ersten und des zweiten Bandes (T1, T2), die auf dem ersten und dem zweiten Transportweg (60a, 60b) transportiert werden, sowie die ersten und die zweiten Bauteile (e1, e2), die in den ersten und den zweiten Hohlräumen (Ct1, Ct2) gespeichert sind, an ersten und zweiten Erfassungs-Positionen (Ld1, Ld2) erfassen, die auf dem ersten bzw. dem zweiten Transportweg (60a, 60b) vorhanden sind;
eine Steuervorrichtung, die jede Funktion der ersten und der zweiten Band-Transportvorrichtung (50, 51), der ersten und der zweiten Schneid-Vorrichtung (54, 55) sowie einer Verbindungsvorrichtung (58) steuert,
**dadurch gekennzeichnet, dass** die Steuervorrichtung aufweist:
eine Zwischenraum-Berechnungseinrichtung (S10) zum Berechnen des vorgegebenen Zwischenraums zwischen den ersten und den zweiten Hohlräumen (Ct1, Ct2) auf Basis der ersten und/oder zweiten Hohlräume (Ct1, Ct2), die an der ersten und/oder der zweiten Erfassungsvorrichtung (52, 53) erfasst werden;
eine erste und eine zweite Schneidpunkt-Berechnungsvorrichtung zum Berechnen des ersten bzw. des zweiten Schneidpunktes (Q1, Q2) des ersten und des zweiten Bandes (T1, T2) aus einem ersten Abstand (D1) zwischen der ersten Erfassungs-Position (Ld1) und der ersten Schneid-Position (Lc1) sowie einen zweiten Abstand (D2) zwischen der zweiten Erfassungs-Position (Ld2) und der zweiten Schneid-Position (Lc2) und dem durch die Zwischenraum-Berechnungseinrichtung (S10) berechneten Zwischenraum (Pc) auf Basis eines ersten und eines zweiten Bauteil-Vorhandensein-Signals, das ausgegeben wird, nachdem die erste und die zweite Erfassungsvorrichtung (52, 53) einen Übergang von ersten und zweiten Hohlräumen (Ct1, Ct2) ohne die ersten und die zweiten Bauteile (e1, e2) zu ersten und zweiten Hohlräumen (Ct1, Ct2) mit den ersten und den zweiten Bauteilen (e1, e2) erfassen; sowie
eine erste und eine zweite Schneid-Positions-Festlegeeinrichtung (S14), die die erste und die zweite Band-Transportvorrichtung (50, 51) steuern und das erste sowie das zweite Band (T1, T2) über eine erste und eine zweite Strecke (D1, D2) bewegen, nachdem das erste und das zweite Bauteil-Vorhandensein-Signal ausgegeben wird, um die Transportpositionen des ersten bzw. des zweiten Schneidpunktes (Q1, Q2) an der ersten und der zweiten Schneid-Position (Lc1, Lc2) festzulegen.

2. Automatische Spleißvorrichtung (20) nach Anspruch 1,
wobei die Steuervorrichtung eine erste und eine zweite Spleiß-Positioniereinrichtung verwendet und der erste sowie der zweite Schneidpunkt (Q1, Q2), die an der ersten und der zweiten Schneid-Position (Lc1, Lc2) platziert sind mit der ersten und der zweiten Schneidvorrichtung (54, 55) geschnitten werden, und die erste sowie die zweite Band-Transportvorrichtung (50, 51) so gesteuert werden, dass der erste und der zweite Schneidpunkt (Q1, Q2) über eine dritte und eine vierte Strecke (D3, D4) zwischen dem ersten und dem zweiten Schneidpunkt (Q1, Q2) und der Spleiß-Position (LS) bewegt werden, sodass der erste und der zweite Schneidpunkt (Q1, Q2) an der Spleiß-Position (LS) platziert werden.

3. Automatische Spleißvorrichtung (20) nach Anspruch 1 oder 2,
wobei die erste und die zweite Schneidvorrichtung (54, 55) umfassen:
eine erste und eine zweite Schneideinrichtung (68a, 68b), die den ersten und den zweiten Schneidpunkt (Q1, Q2) schneiden, die an der ersten und der zweiten Schneid-Position (Lc1, Lc2) des ersten und des zweiten Bandes (T1, T2) platziert sind, und die so angebracht sind, dass sie nach oben und nach unten bewegt werden können; und
ein erstes und ein zweites Presselement (36a, 36b), die so an die erste und die zweite Schneideinrichtung (68a, 68b) angrenzen, dass sie sich nach oben und nach unten bewegen können, und die den Bereich um den ersten und den zweiten Schneidpunkt (Q1, Q2) des ersten und des zweiten Bandes (T1, T2) pressen und fixieren, die an der ersten bzw. der zweiten Schneid-Position (Lc1, Lc2) positioniert sind.

## Revendications

1. Dispositif d'épissage automatique (20) qui connecte une première bande (T1) et une deuxième bande (T2) pourvues de cavités (Ct1, Ct2) pour stocker des composants (Q1, e2) et de trous d'indexation (Hc1, Hc2) à des intervalles fixés en utilisant une bande d'épissage (30), comprenant :
des premier et deuxième dispositifs de coupe (54, 55) pour couper respectivement à des première et deuxième positions de coupe (Lc1, Lc2) les sections superflues respectives à l'extrémité de queue de la première bande (T1) et à l'extrémité de tête de la deuxième bande (T2) ;
des premier et deuxième dispositifs d'indexation de bande (50, 51) pour convoyer les première et deuxième bandes (T1, T2) respectivement le long de première et deuxième voies de convoyage (60a, 60b) et pour positionner les points de coupe (Q1, Q2) des première et deuxième bandes (T1, T2) dans l'ordre aux première et deuxième positions de coupe (Lc1, Lc2) et à la position d'épissage (LS) ;
des premier et deuxième dispositifs de détection (52, 53) pour détecter respectivement les première et deuxième cavités (Ct1, Ct2) des première et deuxième bandes (T1, T2) convoyées le long des première et deuxième voies de convoyage (60a, 60b), et les premier et deuxième composants (Q1, e2) stockés dans les première et deuxième cavités (Ct1, Ct2), à des première et deuxième positions de détection (Ld1, Ld2) pourvues respectivement dans les première et deuxième voies de convoyage (60a, 60b) ;
un dispositif de contrôle pour contrôler chaque opération des premier et deuxième dispositifs d'indexation de bande (50, 51), des premier et deuxième dispositifs de coupe (54, 55) et d'un dispositif de jonction (58) ;
**caractérisé en ce que** le dispositif de contrôle comporte :
un moyen de calcul de pas (S10) pour calculer le pas prédéterminé entre les première et deuxième cavités (Ct1, Ct2) sur base d'au moins l'une des première et deuxième cavités (Ct1, Ct2) détectées sur au moins l'un des premier et deuxième dispositifs de détection (52, 53) ;
un dispositif de calcul des premier et deuxième points de coupe pour calculer respectivement les premier et deuxième points de coupe (Q1, Q2) des première et deuxième bandes (T1, T2) à partir d'une première distance (D1) entre la première position de détection (Ld1) et la première position de coupe (Lc1) et d'une deuxième distance (D2) entre la deuxième position de détection (Ld2) et la deuxième position de coupe (Lc2), et le pas prédéterminé (Pc) calculé par le moyen de calcul de pas (S10), sur base d'un signal de présence des premier et deuxième composants envoyé après que les premier et deuxième dispositifs de détection (52, 53) ont détecté une commutation depuis des première et deuxième cavités (Ct1, Ct2) sans les premier et deuxième composants (Q1, e2) vers des première et deuxième cavités (Ct1, Ct2) avec les premier et deuxième composants (Q1, e2) ; et
des premier et deuxième moyens de décision de position de coupe (S14) qui contrôlent les premier et deuxième dispositifs d'indexation de bande (50, 51) et déplacent les première et deuxième bandes (T1, T2) sur des première et deuxième distances (D1, D2) après que le signal de présence des premier et deuxième composants a été envoyé pour décider respectivement des positions de convoyage des premier et deuxième points de coupe (Q1, Q2) aux première et deuxième positions de coupe (Lc1, Lc2).

2. Dispositif d'épissage automatique (20) selon la revendication 1,
dans lequel le dispositif de contrôle utilise des premier et deuxième moyens de positionnement d'épissage moyennant lesquels, quand les premier et deuxième points de coupe (Q1, Q2) positionnés aux première et deuxième positions de coupe (Lc1, Lc2) sont coupés par les premier et deuxième dispositifs de coupe (54, 55), les premier et deuxième dispositifs d'indexation de bande (50, 51) sont contrôlés de telle sorte que les premier et deuxième points de coupe (Q1, Q2) sont déplacés sur des troisième et quatrième distances (D3, D4) entre les premier et deuxième points de coupe (Q1, Q2) et la position d'épissage (LS) de telle sorte que les premier et deuxième points de coupe (Q1, Q2) sont positionnés à la position d'épissage (LS).

3. Dispositif d'épissage automatique (20) selon la revendication 1 ou 2,
dans lequel les premier et deuxième dispositifs de coupe (54, 55) comprennent :
des premier et deuxième couteaux (68a, 68b) qui coupent les premier et deuxième points de coupe (Q1, Q2) positionnés aux première et deuxième positions de coupe (Lc1, Lc2) des première et deuxième bandes (T1, T2) et qui sont fixés de manière à être mobiles vers le haut et vers le bas ; et
des premier et deuxième éléments de compression (36a, 36b) pourvus de manière adjacente aux premier et deuxième couteaux (68a, 68b) de manière à ce qu'ils puissent se déplacer vers le haut et vers le bas, qui poussent et fixent la zone autour des premier et deuxième points de coupe (Q1, Q2) des première et deuxième bandes (T1, T2) respectivement positionnées aux première et deuxième positions de coupe (Lc1, Lc2).
